# EUROPEAN PATENT APPLICATION

(11) **EP 4 340 570 A1**
(43) Date of publication of application: **20.03.2024**
(21) Application number: 22945120.8
(22) Date of filing: 08.11.2022
(51) Int. Cl.: H10K 59/10

(54) **DISPLAY PANEL AND DISPLAY DEVICE**

(30) Priority: 24.06.2022 CN 202210726487
(71) Applicant: Hefei Visionox Technology Co., Ltd., Hefei, Anhui 230000 (CN); KUNSHAN GO-VISIONOX OPTO-ELECTRONICS CO., LTD., Kunshan, Jiangsu 215300 (CN)
(72) Inventor: WU, Chunyan, Hefei, Anhui 230000 (CN); ZHOU, Qi, Hefei, Anhui 230000 (CN); TAN, Bing, Hefei, Anhui 230000 (CN); XIE, Fei, Hefei, Anhui 230000 (CN); ZHU, Xiujian, Hefei, Anhui 230000 (CN)
(74) Representative: Arnold & Siedsma
(86) International application number: PCT/CN2022/130699
(87) International publication number: WO 2023/245959

(57) **Abstract**

Provided are a display panel and a display device, including: a light-emitting region and a non-light-emitting region located at a periphery of the light-emitting region; the display panel includes a light-emitting side and a backlighting side disposed opposite to each other along a thickness direction; the display panel includes a touch layer and a filter layer located in the touch layer, the filter layer includes a color filter, the touch layer includes first and second touch wires, and the second touch wire is located at the first touch wire close to the light-emitting side; the color filter includes first and second color filters, the first color filter is located at the light-emitting region, the second color filter and the first and second touch wires are all located at the non-light-emitting region, and the second color filter is located between the first and second touch wires; the first and second color filters are disposed to be in same layer and of same material. The filter layer is integrated in the touch layer. In addition, the first and second color filters can be prepared simultaneously. Therefore, the display panel and the display device provided in the present application can simplify a process of preparing the display panel, thereby simplifying a process of preparing the display device.

## Description

The present application claims priority to Chinese Patent Application No. 202210726487.6, entitled with "DISPLAY PANEL AND DISPLAY DEVICE", filed with the China National Intellectual Property Administration (CNIPA) on June 24, 2022, the disclosure of which is incorporated in the present application by reference in its entirety.

### TECHNICAL FIELD

The present application relates to the technology field of display panel and, in particular, to a display panel and a display device.

### BACKGROUND

Organic light-emitting diode (abbreviated as OLED) has the characteristics such as active luminescence, high contrast ratio, ultra-thinness and lightweight, low-temperature resistance, fast response speed, low power consumption, wide viewing angle, and strong shock resistance, thereby leading to more and more applications.

In related technology, the display panel includes a light-emitting region and a non-light-emitting region located at the periphery of the light-emitting region. The display panel includes a touch layer and a filter layer located on the touch layer, and the filter layer includes a color filter layer and a light-shielding layer, where the color filter layer is located at the light-emitting region and the light-shielding layer is located at the non-light-emitting region.

However, the aforementioned process of preparing the display panel is more complicated.

### SUMMARY

In view of at least one of the aforementioned technical problems, embodiments of the present application provide a display panel and a display device, which can simplify a process of preparing the display panel and the display device.

In order to realize the aforementioned object, embodiments of the present application provide the following technical solutions.

A first aspect of embodiments of the present application provides a display panel, including: a light-emitting region and a non-light-emitting region located at a periphery of the light-emitting region; the display panel includes a light-emitting side and a backlight side disposed opposite to each other along a thickness direction.

The display panel includes a touch layer and a filter layer located in the touch layer, the filter layer includes a color filter, the touch layer includes a first touch wire and a second touch wire, the second touch wire is located at the first touch wire close to the light-emitting side; the color filter includes a first color filter and a second color filter, the first color filter is located at the light-emitting region, the second color filter, the first touch wire and the second touch wire are all located at the non-light-emitting region, and the second color filter is located between the first touch wire and the second touch wire; the second color filter and the first color filter are disposed to be in same layer and of same material, and a gap is provided between the first color filter and the second color filter.

For the display panel of embodiments of the present application, the display panel may include the light-emitting region and the non-light-emitting region located at the periphery of the light-emitting region; the display panel includes the light-emitting side and the backlight side disposed opposite to each other along its thickness direction. The display panel may include the touch layer and the filter layer located in the touch layer, and the filter layer is configured for reducing the reflection of ambient light, thereby improving display effect of the display panel. Since the filter layer is integrated in the touch layer, the number of total structural layers of the touch layer and the filter layer can be reduced (e.g., the filter layer can be configured for partially or completely replacing a first insulating layer and/or a second insulating layer in the touch layer), thereby simplifying a process of preparing the touch layer and the filter layer. The filter layer may include the color filter, the touch layer includes the first touch wire and the second touch wire, the second touch wire is located at the first touch wire close to the light-emitting side; the color filter includes the first color filter and the second color filter, the first color filter is located at the light-emitting region and may be configured for filtering light of the ambient light that is different from its own color, playing the role of filtering light. The second color filter, the first touch wire and the second touch wire are all located at the non-light-emitting region, and the second color filter is located between the first touch wire and the second touch wire and can electrically isolate the first and second touch wires. Where, the second color filter and at least part of the first color filter are disposed to be in same layer and of same material, so that the first and second color filters can be prepared simultaneously to simplify a process of preparing the first and second color filters, thereby simplifying a process of preparing the display panel and the display device.

In a possible implementation, the first color filter includes a plurality of sub-color filters that have different colors and are disposed at intervals, and the second color filter and at least one color of the sub-color filters are disposed to be in same layer and of same material.

It may be realized that the first color filter has a thickness in a range of 0.5 µm-5 µm; and/or, the second color filter has a thickness in a range of 0.5 µm-15 µm; and/or, the color filter has a dielectric constant of less than or equal to 10; and/or, the color filter has a surface impedance of greater than or equal to 10¹¹ Q/square.

In this way, the first color filter can be prepared simultaneously with the second color filter, thereby simplifying a process of preparing the display panel and the display device.

In a possible implementation, the second color filter has a via-hole through the second color filter along a thickness direction, and the second touch wire covers a hole wall surface of the via-hole and is connected with the first touch wire.

An opening of the via-hole gradually increases along a direction from the backlight side to the light-emitting side.

In this way, it is less likely to have a gap between the second touch wire and the hole wall surface of the via-hole, having a more stable connection between them.

In a possible implementation, the filter layer further includes a light-shielding layer, at least part of the light-shielding layer is located at the second touch wire close to the light-emitting side.

It may be realized that a positive projection of the light-shielding layer on a plane where the first touch wire is located covers the first touch wire; and/or, a positive projection of the light-shielding layer on a plane where the second touch wire is located covers the second touch wire.

In this way, the light-shielding layer may avoid reflection of ambient light, thereby ensuring the display effect of the display panel.

In a possible implementation, at least part of the first color filter extends to the non-light-emitting region, the light-shielding layer is located at the first color filter close to the light-emitting side, and a positive projection of the first color filter located in the non-light-emitting region on a plane where the light-shielding layer is located partially overlaps the light-shielding layer.

It may be realized that a positive projection of the second touch wire on a plane where the second color filter is located is located on an inner side of an outer edge of the second color filter.

In this way, it can be avoided that a process error causes a pore to appear between the first color filter and the light-shielding layer, and the absence of the first color filter at the pore will cause the light not to be filtered, thereby affecting the display effect of the display panel.

In a possible implementation, a gap is disposed between the first color filter and the second color filter, and the light-shielding layer is located in the gap.

It may be realized that the space between the first color filter and the second color filter gradually increases along the direction from the backlight side to the light-emitting side.

In this way, the light-shielding layer may function to protect the first touch wire, the second touch wire and the second color filter.

In a possible implementation, the touch layer is provided with a protective layer, and at least part of the protective layer is located at the first color filter close to the light-emitting side.

In this way, the protective layer may protect other structural layers in the touch layer.

In a possible implementation, the protective layer includes a first protective layer, which covers a surface of the first color filter close to the light-emitting side.

It may be realized that a refractive index of the first color filter is less than a refractive index of the first protective layer.

It may be realized that the display panel includes an adhesive layer, the adhesive layer is located at the touch layer close to the light-emitting side, and a refractive index of the adhesive layer is less than a refractive index of the first protective layer.

In this way, the first protective layer may protect the first color filter.

In a possible implementation, the protective layer includes a second protective layer, the second protective layer is located on a surface of the light-shielding layer close to the light-emitting side and/or the backlight side; it may be realized that the first protective layer and the second protective layer are integrated into one piece.

In this way, the second protective layer may protect the first touch wire, the second touch wire and the second color filter.

A first aspect of embodiments of the present application provides a display device, including the display panel in the aforementioned first aspect.

For the display device provided in the embodiments of the present application, the display device includes a display panel, the display panel may include a light-emitting region and a non-light-emitting region located at a periphery of the light-emitting region; the display panel includes a light-emitting side and a backlight side disposed opposite to each other along a thickness direction. The display panel may include a touch layer and a filter layer located in the touch layer, the filter layer is configured for reducing the reflection of ambient light, thereby improving display effect of the display panel. Since the filter layer is integrated in the touch layer, the number of total structural layers of the touch layer and the filter layer can be reduced (e.g., the filter layer can be configured for partially or completely replacing the first insulating layer and/or the second insulating layer in the touch layer), thereby simplifying a process of preparing the touch layer and the filter layer. The filter layer may include a color filter, the touch layer includes a first touch wire and a second touch wire, the second touch wire is located at the first touch wire close to the light-emitting side; the color filter includes a first color filter and a second color filter, the first color filter is located at the light-emitting region and may be configured for filtering a light of the ambient light that is different from its own color, playing the role of filtering light. The second color filter, the first touch wire and the second touch wire are all located at the non-light-emitting region, and the second color filter is located between the first touch wire and the second touch wire, and the second color filter can electrically isolate the first touch wire and the second touch wire. Where, the second color filter and at least part of the first color filter are disposed to be in same layer and of same material, so that the first color filter can be prepared simultaneously with the second color filter to simplify a process of preparing the first and second color filters, thereby simplifying a process of preparing the display panel and the display device.

The construction of the present application, and its other inventive purposes and beneficial effects will be more obvious and easily understood by describing the preferred embodiments in conjunction with the accompanying drawings.

### BRIEF DESCRIPTION OF DRAWINGS

To illustrate the technical solutions in embodiments of the present application or in the prior art more clearly, the following briefly introduces the accompanying drawings required for describing the embodiments or the prior art. Apparently, the accompanying drawings in the following description illustrate merely some embodiments of the present application, and persons of ordinary skill in the art may still derive other drawings from these accompanying drawings without creative effort.
FIG. 1 is a structural schematic diagram of a display panel provided by an embodiment of the present application.
FIG. 2a is another structural schematic diagram of the display panel provided by an embodiment of the present application.
FIG. 2b is another structural schematic diagram of the display panel provided by an embodiment of the present application.
FIG. 3 is a partial structural schematic diagram of a touch layer provided by an embodiment of the present application.
FIG. 4 is another partial structural schematic diagram of the touch layer provided by an embodiment of the present application.
FIG. 5 is another partial structural schematic diagram of the touch layer provided by an embodiment of the present application.
FIG. 6 is another partial structural schematic diagram of the touch layer provided by an embodiment of the present application.

### Description of reference numbers:

| | | | |
|---|---|---|---|
| 100 | -display panel; | 100a | -light-emitting region; |
| 100b | -non-light-emitting region; | 110 | -array substrate; |
| 120 | -light-emitting layer; | 121 | -pixel layer; |
| 122 | -pixel limiting layer; | 130 | -encapsulation layer; |
| 140 | -buffer layer; | 150 | -adhesive layer; |
| 160 | -cover plate; | 170 | -touch layer; |
| 171 | -first touch wire; | 172 | -second touch wire; |
| 174 | -first protective layer; | 175 | -second protective layer; |
| 181 | -light-shielding layer; | 182 | -color filter; |
| 183 | -first color filter; | 185 | -second color filter; |
| 186 | -via-hole; | 187 | -gap. |

### DESCRIPTION OF EMBODIMENTS

In related technology, a display panel includes a light-emitting region and a non-light-emitting region disposed at a periphery of the light-emitting region. The display panel includes a touch layer and a filter layer located on the touch layer, the filter layer includes a color filter layer and a light-shielding layer, where the color filter layer is located at the light-emitting region and the light-shielding layer is located at the non-light-emitting region. The touch layer includes a first touch wire, a first insulating layer, a second touch wire, and a second insulating layer that are stacked in sequence, where the first touch wire and the second touch wire are located at the non-light-emitting region, and each of the first insulating layer and the second insulating layer is located at the light-emitting region and the non-light-emitting region.

However, the total structural layers in the aforementioned touch layer and filter layer are more, and the respective structural layers are prepared separately. For example, the first touch wire, the first insulating layer, the second touch wire, the second insulating layer, the light-shielding layer, and the color filter layer need to be prepared in sequence, which makes a process of preparing the touch layer and the filter layer more complicated, thereby causing a process of preparing the display panel and the display device to be more complicated.

Based on at least one of the aforementioned technical problems, embodiments of the present application provide a display panel and a display device. The display panel may include a light-emitting region and a non-light-emitting region disposed at a periphery of the light-emitting region; the display panel includes a light-emitting side and a backlighting side disposed opposite to each other along its thickness direction. The display panel may include a touch layer and a filter layer located in the touch layer, and the filter layer is configured for reducing the reflection of ambient light, thereby improving the display effect of the display panel. Since the filter layer is integrated in the touch layer, the number of total structural layers of the touch layer and the filter layer can be reduced (e.g., the filter layer can be configured for partially or completely replacing a first insulating layer and/or a second insulating layer in the touch layer), thereby simplifying a process of preparing the touch layer and the filter layer. In addition, it is also conducive to the lightweight and thinness of the display panel and the display device. The filter layer may include a color filter, the touch layer includes a first touch wire and a second touch wire, the second touch wire is located at the first touch wire close to the light-emitting side; the color filter includes a first color filter and a second color filter, the first color filter is located at the light-emitting region and may be configured for filtering a light of the ambient light that is different from its own color, playing the role of filtering light. The second color filter, the first touch wire and the second touch wire are all located at the non-light-emitting region, the second color filter is located between the first touch wire and the second touch wire, and can electrically isolate the first touch wire and the second touch wire. Where, the second color filter and at least part of the first color filter are disposed to be in same layer and of same material, so that the first color filter can be prepared simultaneously with the second color filter to simplify a process of preparing the first and second color filters, thereby simplifying a process of preparing the display panel and the display device.

To make the objects, technical solutions and advantages of the embodiments of the present application more clearly, the following will clearly and completely describe the technical solutions in the embodiments of the present application with reference to the accompanying drawings in the embodiments of the present application. Apparently, the embodiments as described are a part of the embodiments of the present application, and not all of the embodiments. Based on the embodiments in the present application, all other embodiments obtained by persons of ordinary skill in the art without creative effort fall within the scope of protection of the present application.

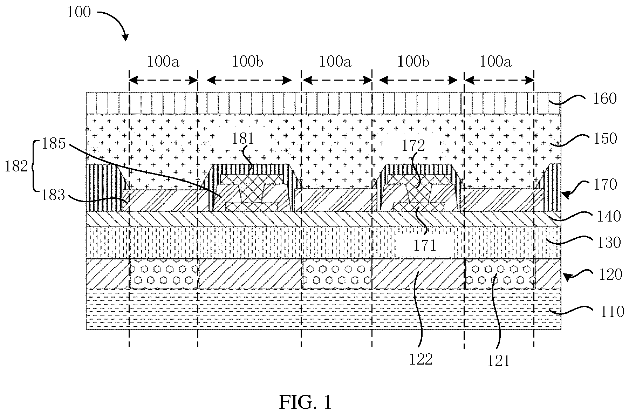

The following will illustrate the display device provided by embodiments of the present application in combination with FIG. 1- FIG. 6.

The present embodiment provides a display device, including a display panel 100. The display device may be a mobile or immobile terminal having the display panel 100, such as an electronic paper, a mobile phone, a tablet computer, a television, a display, a laptop computer, a digital photo frame, a smart bracelet, a smart watch, a super personal computer, and a navigator.

The display panel 100 may be an organic light-emitting diode (Organic Light-Emitting Diode, abbreviated as OLED) display panel, a micro light-emitting diode (Micro Light Emitting Diode, abbreviated as Micro LED or µLED) display panel, or a liquid crystal display (Liquid Crystal Display, abbreviated as LCD) display panel.

The embodiments of the present application are illustrated by the example of the display panel 100 being an OLED display panel.

The following illustrates the display panel 100 provided by the embodiments of present application.

The present embodiment provides a display panel 100, which can be applied to the aforementioned display device.

The display panel 100 may include a light-emitting side and a backlight side disposed opposite to each other along its thickness direction. The light-emitting side is a side for displaying a picture, and the backlight side is another side disposed opposite to the light-emitting side along a thickness direction of the display panel 100.

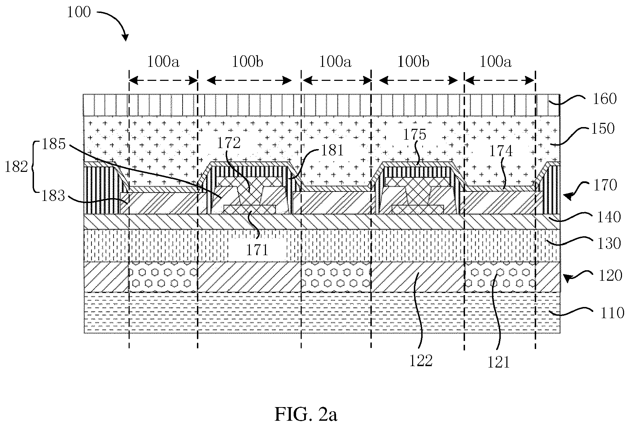

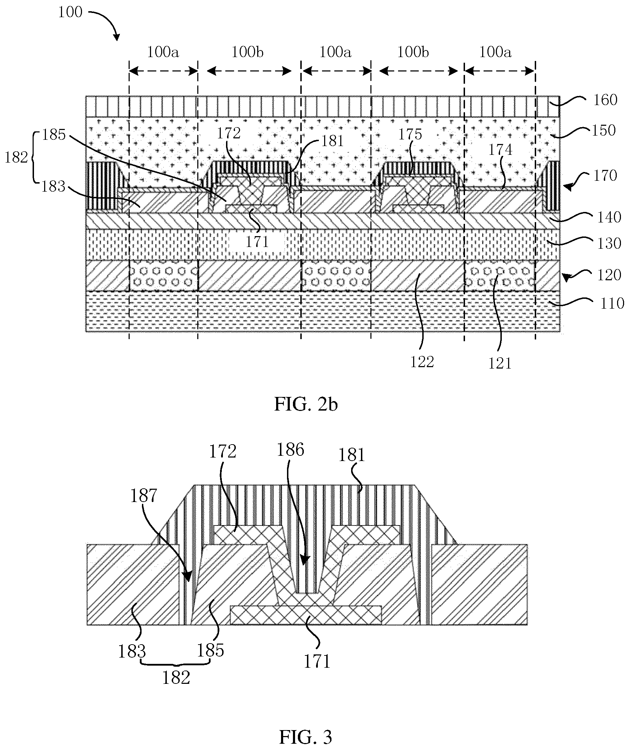

As shown in FIG. 1, FIG. 2a, and FIG. 2b, the display panel 100 may include an array substrate 110 and a light-emitting layer 120 located on the array substrate 110. The array substrate 110 is provided with a plurality of drive units which may be arranged in an array, and the drive units are electrically connected with the light-emitting layer 120 and are configured for providing a drive current to the light-emitting layer 120. The drive unit may include a thin film transistor (Thin Film Transistor, abbreviated as TFT) and a capacitor structure. For example, the thin film transistor may include at least one of a metal oxide (Metal Oxide, abbreviated as MO) thin film transistor and a low temperature poly-silicon (Low Temperature Poly-silicon, abbreviated as LTPS) thin film transistor.

The following illustrates the light-emitting layer 120 provided by the embodiments of present application.

The light-emitting layer 120 may include an anode layer and a cathode layer, the anode layer is located at a side of the cathode layer facing the array substrate 110. The anode layer may be a pixel electrode and the cathode layer may be a common electrode.

As shown in FIG. 1, the light-emitting layer 120 may include a pixel layer 121 and a pixel limiting layer 122, and the pixel layer 121 is formed of a light-emitting material and is located between the anode layer and the cathode layer. The pixel layer 121 may generally include a plurality of pixels, the plurality of pixels may be arranged in an array, and the plurality of pixels may include, but are not limited to, red pixel, green pixel, and blue pixel. In other examples, the plurality of pixels may also include white pixel. The pixel limiting layer 122 is located between two neighboring pixels and may be disposed around the periphery of the pixels.

The light-emitting layer 120 may also include at least one of a hole injection layer, a hole transport layer, an electron blocking layer, a hole blocking layer, an electron transport layer, and an electron injection layer.

It can be understood that, as shown in FIG. 1, the display panel 100 includes light-emitting regions 100a and non-light-emitting regions 100b, and the light-emitting region 100a corresponds to a pixel and may overlap with the pixel; furthermore, the non-light-emitting region 100b is provided between neighboring light-emitting regions 100a, the non-light-emitting region 100b may be disposed around an outer periphery of the light-emitting region 100a, and the non-light-emitting region 100b may correspond to at least part of the pixel limiting layer 122.

The display panel 100 may also include any one or more of an encapsulation layer 130, a touch layer 170, and a cover plate 160.

The display panel 100 may also include the encapsulation layer 130. The encapsulation layer 130 is located at a side of the light-emitting layer 120 facing away from the array substrate 110, and is configured for sealing the light-emitting layer 120 to prevent external water and oxygen from penetrating into the light-emitting layer 120 and the drive units and damaging the display panel 100.

Exemplarily, the encapsulation layer 130 may adopt a thin film encapsulation (Thin Film Encapsulation, abbreviated as TFE) technology. The TFE encapsulation layer 130 may include a plurality of encapsulation sub-film layers, and the TFE may adopt a multi-layer stacked structure of inorganic layer/organic layer/inorganic layer overlapping. Among them, the inorganic layer is configured for effectively blocking water and oxygen, and the organic layer is configured for buffering the stress within the inorganic layer.

As shown in FIG. 1, the display panel 100 may also include a touch layer 170, which is located at a side of the encapsulation layer 130 facing away from the array substrate 110, and the touch layer 170 is configured for realizing a touch function. The display panel 100 may include the cover plate 160, which is located at a side of the touch layer 170 facing away from the array substrate 110, and the cover plate 160 is configured for protecting the display panel 100, so as to avoid scratching the display panel 100 when a user uses the display panel 100. That is, the touch layer 170 is disposed between the cover plate 160 and the encapsulation layer 130.

Exemplarily, a buffer layer 140 may be provided between the touch layer 170 and the encapsulation layer 130, and the buffer layer 140 may be formed of an inorganic material (e.g., silicon nitride, silicon oxide, etc.) or an organic material. Of course, it is also possible to set the touch layer 170 directly on the encapsulation layer 130 without providing the buffer layer 140, thereby facilitating lightweight and thinness of the display panel 100.

Exemplarily, an adhesive layer 150 may be provided between the cover plate 160 and the touch layer 170, and the adhesive layer 150 is configured for connecting the cover plate 160 with the touch layer 170. Furthermore, the adhesive layer 150 may also be configured for providing a flat surface to facilitate the connection between the cover plate 160 and the touch layer 170. For example, the adhesive layer 150 may be formed of a material such as an optically transparent adhesive, an optically transparent resin, or a pressure-sensitive adhesive.

The following illustrates the touch layer 170 provided by the embodiments of present application.

As shown in FIG. 1, the touch layer 170 may include a first touch wire 171 and a second touch wire 172, and the second touch wire 172 is located at the first touch wire 171 close to the light-emitting side, i.e., the second touch wire 172 is located at a side of the first touch wire 171 facing away from the light-emitting layer 120.

In the touch layer 170, one of the first touch wire 171 and the second touch wire 172 forms a bridging layer, and the other of the first touch wire 171 and the second touch wire 172 may form a touch function layer. The touch function layer may include a plurality of first touch electrodes extending along a first direction, and a plurality of second touch electrodes extending along a second direction. Where, the first direction and the second direction are different, for example, the first direction may be a length direction of the display panel 100, and the second direction may be a width direction of the display panel 100.

The length, width, and thickness described in the embodiments of the present application are merely for ease of description and do not imply any limitation on the dimensions. For example, the length may be greater than, equal to, or less than the width.

Exemplarily, one of the first touch electrode and the second touch electrode is a driving electrode, and the other of the first touch electrode and the second touch electrode is a sensing electrode. It should be noted that, although both the driving electrode and the sensing electrode are formed by the second touch wire 172, they are insulated from each other. One of the driving electrode and the sensing electrode is an uninterrupted structure along the first direction (or the second direction); and the other of the drive electrode and the sense electrode includes a plurality of spaced sub-structures along the second direction (or the first direction), which are connected with each other by bridging via the bridging layer.

Exemplarily, the first touch wire 171 and the second touch wire 172 may be each located at the non-light-emitting region 100b, thereby avoiding the impact on the opening ratio of the display panel 100.

Exemplarily, the first touch wire 171 and the second touch wire 172 may be a single conducting layer, and also may be a stacked structure of multiple-layer conducting layers.

A filter layer may be integrated in the touch layer 170, and the filter layer may be configured for replacing at least part of other insulating material layer except for the first touch wire 171 and the second touch wire 172 in the touch layer 170, so that the overall thickness of the display panel 100 may be smaller to facilitate lightweight and thinness of the display panel 100; furthermore, the display panel 100 after light-weighting and thinning has a better bending performance.

The following illustrates the filter layer provided by the embodiments of present application.

The filter layer may be configured for reducing the reflection of ambient light, thereby improving the display effect of the display panel 100.

The filter layer may include a color filter 182, and the color filter 182 may be configured for filtering a light of the ambient light that is different from its own color. The color filter 182 may be formed using an organic material and is more flexible, thereby facilitating the bending performance of the display panel 100.

In some embodiments, as shown in FIG. 1, the color filter 182 may include a first color filter 183 located at the light-emitting region 100a. The first color filter 183 is disposed in one-to-one correspondence with the pixel, and a positive projection of the first color filter 183 on the light-emitting layer 120 covers the pixel and is of the same color as the covered pixel to avoid light mixing. For example, a first color filter 183 corresponding to the red pixel is a red sub-color filter, which may block light emitted from the blue pixel and the green pixel and allow red light emitted from the red pixel or the white pixel to pass through.

It is understood that the first color filter 183 may include a plurality of sub-color filters that have different colors and are disposed at intervals, for example, any one or more of a red sub-color filter, a green sub-color filter, a blue sub-color filter, and a white sub-color filter. Its principle has been set forth and will not be repeated.

In some embodiments, the color filter 182 may include a second color filter 185 located between the first touch wire 171 and the second touch wire 172, and the second color filter 185 may electrically isolate the first touch wire 171 and the second touch wire 172. For example, the second color filter 185 may be formed by using an organic material with a lower dielectric constant, thereby reducing parasitic capacitance of the second touch wire 172 to improve touch performance.

Exemplarily, the color filter 182 may have a dielectric constant of less than or equal to 10, e.g., the color filter 182 may have a dielectric constant of 1, 3, 5, 7, 10, or any value below 10, thereby reducing parasitic capacitance of the second touch wire 172 to improve touch performance. The color filter 182 may have a surface impedance of greater than or equal to 10¹¹ Q/square, for example, the color filter 182 may have a surface impedance of 10¹¹ Q/square, 10¹² S2/square, 10¹³ Q/square, or 10¹⁴ Ω/square, and the like, thereby being able to electrically isolate the first touch wire 171 and the second touch wire 172 better.

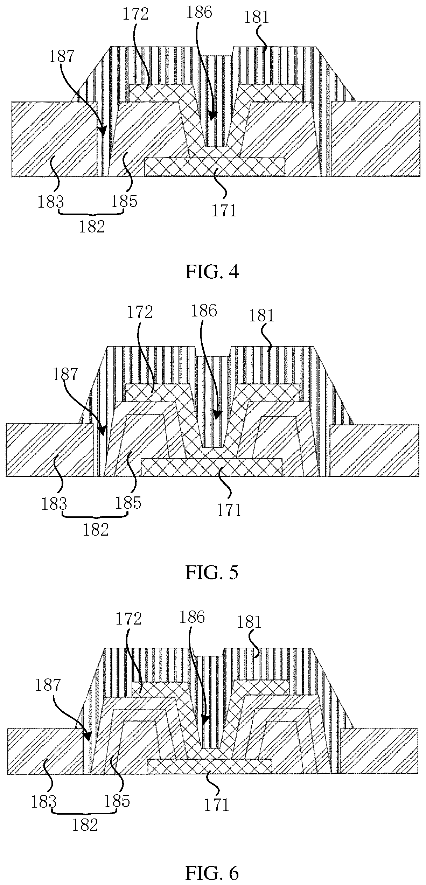

Exemplarily, as shown in FIG. 3 and FIG. 4, the second color filter 185 may have a plurality of via-holes 186 running through the second color filter 185 along its thickness direction, and the first touch wire 171 and the second touch wire 172 are connected by bridging through the via-hole 186. The second touch wire 172 covers a surface on a side of the second color filter 185 facing away from the light-emitting layer 120, and extends into the via-hole 186 and covers the hole wall surface of the via-hole 186 so as to be electrically connected with the first touch wire 171 through the via-hole 186.

For example, the opening of the via-hole 186 is gradually enlarged along the direction from the backlight side to the light-emitting side, i.e., along the direction from the light-emitting layer 120 to the touch layer 170. At this point, the cross-section of the via-hole 186 is an inverted trapezoidal shape, the hole wall surface of the via-hole 186 is disposed in an inclined manner, and the hole wall surface of the via-hole 186 includes a first end close to the cover plate 160 and a second end close to the light-emitting layer 120. In the second color filter 185 provided with the via-hole 186, the first end is closer to an edge of the second color filter 185 as compared with the second end, i.e., the first end is slanted towards an edge of the second color filter 185 compared to the second end. Thereby, the second touch wire 172 can be made to better cover the hole wall surface of the via-hole 186, it is not easy to appear a pore between the second touch wire 172 and the hole wall surface of the via-hole 186, and the attachment of the second touch wire 172 is more stable and is not easy to be broken.

Exemplarily, a positive projection of the second touch wire 172 on a plane where the second color filter 185 is located may be located inside an outer edge of the second color filter 185. That is, the size of the second color filter 185 (including the via-hole 186) may be larger than that of the second touch wire 172, an edge of the second color filter 185 will protrude from the edge of the second touch wire 172, and the second color filter 185 will have a better support effect on the second touch wire 172; furthermore, the edge of the second touch wire 172 is farther away from the cathode layer in the light-emitting layer 120, thereby reducing parasitic capacitance to ensure touch performance.

In this embodiment, the second color filter 185 and at least portion of the first color filter 183 may be disposed in same layer and made of same material, so this portion of the first color filter 183 and the second color filter 185 can be prepared simultaneously. That is, there is no need to prepare this portion of the first color filter 183 and the second color filter 185 separately, which can simplify a process of preparing the first color filter 183 and the second color filter 185, thereby simplifying a process of preparing the display panel 100 and the display device.

Exemplarily, the second color filter 185 may be of the same color as at least one of the sub-color filters having a plurality of colors in the first color filter 183, and the second color filter 185 and the sub-color filter having the same color may be disposed in same layer and be of same material. For example, the second color filter 185 may be prepared simultaneously with the sub-color filter having one of the colors, at this point, a thickness of the first color filter 183 may be equal to a thickness of the second color filter 185. Alternatively, the second color filter 185 may be prepared simultaneously with sub-color filters having two (FIG. 5) or three (FIG. 6) of the colors. When the second color filter 185 is prepared simultaneously with the sub-color filters having the plurality of colors, the thickness of the second color filter 185 may be greater than the thickness of the first color filter 183, and the thickness of the second color filter 185 may be less than the sum of the thickness of the sub-color filters having the plurality of colors. At this point, the thickness of the second color filter 185 is greater, thereby increasing the distance between the second touch wire 172 and the cathode layer in the light-emitting layer 120, and reducing the parasitic capacitance between the second touch wire 172 and the cathode layer to improve the touch performance.

The expression "same layer and same material" in the embodiment of the present application refer to a base film layer formed of the same material, and after the base film layer is subjected to patterning and/or other treatment processes, different parts of the base film layer are formed into multiple structural film layers, respectively. The treatment processes of the different structural layers formed of the base film layer may be the same or different, and the different structural layers formed may have the same or different thickness, and may also be at the same horizontal plane or at different horizontal planes.

Exemplarily, the first color filter 183 may have a thickness in a range of 0.5 µm to 5 µm; furthermore, the second color filter 185 may have a thickness in a range of 0.5 µm to 15 µm. For example, the first color filter 183 may have a thickness of 0.5 µm, 1 µm, 2 µm, 3 µm, 5 µm, or any value between 0.5 µm and 5 µm. The second color filter 185 may have a thickness of 0.5 µm, 2 µm, 5 µm, 10 µm, 15 µm, or any value between 0.5 µm-15 µm. Accordingly, it is possible to avoid too small thickness of the color filter 182 and larger parasitic capacitance of the second touch wire 172, ensuring the touch performance. In addition, it is also possible to avoid too large thickness of the color filter 182, and then avoid a large impact on the thickness of the display panel 100, thereby facilitating the lightweight and thinness of the display panel 100.

As shown in FIG. 3, there is a gap 187 between the first color filter 183 and the second color filter 185 adjacent to each other, i.e., the first color filter 183 and the second color filter 185 adjacent to each other are not connected but independently disposed so as to have a gap 187. Alternatively, the adjacent first color filter 183 and the second color filter 185 may be in contact with each other, e.g., the first color filter 183 and the second color filter 185 adjacent to each other may be an integrated member, so that the adjacent first color filter 183 and second color filter 185 can be prepared simultaneously, thereby improving the overall strength of the adjacent first color filter 183 and second color filter 185.

In an embodiment where there is a gap 187 between the first color filter 183 and the second color filter 185 adjacent to each other, the space of the gap 187 between the first color filter 183 and the second color filter 185 gradually increases along the direction from the backlight side to the light-emitting side. At this point, the sidewall surface of a side of the first color filter 183 close to the second color filter 185 is disposed slantwise, the sidewall surface disposed slantwise can provide better support for other structural layers attached thereto, and the attachment between the other structural layers attached to the sidewall surface and the sidewall surface is more stable, and it is not easy to appear pore, and the principle thereof is similar to that of the hole wall surface of the via-hole 186 being disposed slantwise, and will not be repeated. In addition, the sidewall surface of the second color filter 185 close to the first color filter 183 is disposed slantwise, the principle thereof has been set forth and will not be repeated.

In the present embodiment, as shown in FIG. 3, the filter layer may also include a light-shielding layer 181, and the light-shielding layer 181 may be formed of a material capable of blocking light, which is capable of absorbing light irradiating on the light-shielding layer 181. The light-shielding layer 181 has a larger optical density, and the larger the optical density of the material, the better the light-absorbing effect of the material. For example, the optical density of the light-shielding layer 181 may be greater than or equal to 1, so as to better reduce the ambient reflected light, without providing a polarizer in the display panel 100, thereby reducing the thickness of the display panel 100.

The following illustrates the light-shielding layer 181 provided by the embodiments of present application.

As shown in FIG. 3, at least part of the light-shielding layer 181 is located at the second touch wire 172 close to the light-emitting side, i.e., at least part of the light-shielding layer 181 is located at a side of the second touch wire 172 facing away from the light-emitting layer 120.

Exemplarily, a positive projection of the light-shielding layer 181 on a plane where the first touch wire 171 is located covers the first touch wire 171, i.e., the size of the light-shielding layer 181 is greater than or equal to the size of the first touch wire 171, and a positive projection of the light-shielding layer 181 on the light-emitting layer 120 can cover a positive projection of the first touch wire 171 on the light-emitting layer 120. In this way, it is possible to avoid reflection of ambient light illumination on the first touch wire 171 to improve the display effect of the display panel 100.

Where, a plane where the first touch wire 171 is located refers to a plane where the first touch wire 171 as a whole is generally located, and the length extension direction and the width extension direction of the first touch wire 171 are both located in the plane.

Exemplarily, a positive projection of the light-shielding layer 181 on the plane where the second touch wire 172 is located can cover the second touch wire 172. That is, the size of the light-shielding layer 181 is greater than or equal to the size of the second touch wire 172, and a positive projection of the light-shielding layer 181 on the light-emitting layer 120 can cover a positive projection of the second touch wire 172 on the light-emitting layer 120. Thereby, it is possible to avoid reflection of ambient light illumination on the second touch wire 172 to improve the display effect of the display panel 100.

As shown in FIG. 1, at least part of the first color filter 183 extends to the non-light-emitting region 100b, thereby making the area of the first color filter 183 larger, so that more ambient light irradiates on the first color filter 183, which has a better filtering effect on the ambient light, and can better reduce the reflection of the ambient light to improve the display effect of the display panel 100. At this point, the light-shielding layer 181 may also be located at the first color filter 183 close to the light-emitting side, and the light-shielding layer 181 may cover the edge of the first color filter 183. In the non-light-emitting region 100b, a positive projection of the first color filter 183 on a plane where the light-shielding layer 181 is located is partially overlapped with the light-shielding layer 181. For example, when the light-shielding layer 181 is prepared, the light-shielding layer 181 may deviate from a predetermined position due to the presence of a process error, and the overlapping of the light-shielding layer 181 with the edge of the first color-resist 183 can avoid the emergence of a pore between the light-shielding layer 181 and the first color-resist 183 after the light-shielding layer 181 has deviated from the predetermined position, Without the first color-resist 183 at the pore, light cannot be filtered, thereby affecting the display effect of the display panel 100.

Exemplarily, the light-shielding layer 181 may have a thickness of 1 µm-5 µm, so as to better reduce the reflection of ambient light. The light-shielding layer 181 may have a surface impedance of greater than or equal to 10¹¹ Q/square, so as to make the insulation of the light-shielding layer 181 better.

In an embodiment where there is a gap 187 between the first color filter 183 and the second color filter 185, the light-shielding layer 181 may also be located in the gap 187 between the first color filter 183 and the second color filter 185. At this point, the light-shielding layer 181 encloses the first touch wire 171, the second touch wire 172, and the second color filter 185 all in an accommodating region formed by the enclosure of the light-shielding layer 181. The light-shielding layer 181 covers a larger area, which can better reduce the reflection of ambient light and can better prevent light mixing between neighboring pixels. In addition, the light-shielding layer 181 has a low water permeability, which can prevent the intrusion of water, oxygen, etc., thereby playing a protection role for the first touch wire 171, the second touch wire 172, and the second color filter 185 located in the accommodate region, without separately providing a structural layer for the touch layer 170 to isolate the water and oxygen, thereby facilitating the lightweight and thinness of the display panel 100.

Of course, the touch layer 170 can also be provided with a protective layer to further protect the structural layer in the touch layer 170 from damage caused by water and oxygen intrusion into the touch layer 170. At this point, the protective layer may be set thinner because the light-shielding layer 181 already plays a protection role, thereby avoiding the thickness of the display panel 100 being affected by an excessively thick protective layer.

The following illustrates the protective layer provided by the embodiments of present application.

At least part of the protective layer may be located at the first color filter close to the light-emitting side 183, i.e., at least part of the protective layer may be located at a side of the first color filter 183 facing away from the light-emitting layer 120, thereby functioning to protect the first color filter 183.

Exemplarily, as shown in FIG. 2a and FIG. 2b, the protective layer may include a first protective layer 174, which is located on a surface of the side of the first color filter 183 facing away from the light-emitting layer 120, thereby playing a protection role for the first color filter 183. The first protective layer 174 may cover partial or all area of the first color filter 183.

Exemplarily, the protective layer may include a second protective layer 175, which may be located on a surface of the light-shielding layer 181 close to the light-emitting side, and furthermore, the second protective layer 175 may be located on a surface of the light-shielding layer 181 close to the backlight side. The second protective layer 175 may be located on at least one of two opposite sides of the light-shielding layer 181 along its thickness direction. The second protective layer 175 may be configured for protecting the second color filter 185, the first touch wire 171, and the second touch wire 172.

As shown in FIG. 2a, the second protective layer 175 is located on a side of the light-shielding layer 181 facing away from the light-emitting layer 120, and may protect the light-shielding layer 181.

As shown in FIG. 2b, the second protective layer 175 is located on a side of the light-shielding layer 181 close to the light-emitting layer 120, and may be located in a gap 187. Only the second protective layer 175 may be disposed in the gap 187, or both the second protective layer 175 and the light-emitting layer 181 may be disposed in the gap 187. Of course, the gap 187 may be filled with other filling members.

It may be understood that only the first protective layer 174 may be disposed, or the first protective layer 174 and the second protective layer 175 may be disposed simultaneously. In an embodiment where the first protective layer 174 and the second protective layer 175 are disposed simultaneously, the first protective layer 174 and the second protective layer 175 may be an integrated member, which provides a better protective effect. Of course, the first protective layer 174 and the second protective layer 175 may also be two separate structural layers.

Exemplarily, the thickness of the protective layer may be equal everywhere, and the side of the protective layer away from the light-emitting layer 120 has a non-flush surface. At this point, the protective layer may cover the light-shielding layer 181 and/or the first color filter 183 in the form of a thin film. The protective layer is highly undulating to be in a bent state, which can provide a larger deformation space to dissipate the bending stress when the display panel 100 is bent, thereby playing a protection role for the display panel 100.

Exemplarily, the refractive index of the first color filter 183 may be less than the refractive index of the first protective layer 174, which may reduce the full emission of light from the light-emitting layer 120 at the interface between the first color filter 183 and the first protective layer 174, thereby improving the light-emitting efficiency.

Exemplarily, the refractive index of the adhesive layer 150 may be less than the refractive index of the first protective layer 174, which may prevent the light emitted from pixels from being too concentrated after passing through the adhesive layer 150, resulting in a significant difference in the brightness of the light-emitting region, thereby reducing the phenomenon of color deviation due to large view angle. In addition, the thickness of the first protective layer 174 can be adjusted so that the reflected light of the light emitted from the pixel on the two opposite surfaces of the first protective layer 174 along its thickness direction undergoes destructive interference and offsets each other, thereby increasing the transmittance rate of the light emitted from the pixel and improving the light extraction efficiency.

It may be understood that when the first protective layer 174 and the second protective layer 175 are an integrated member, the second protective layer 175 has the same refractive index as the first protective layer 174. When the first protective layer 174 and the second protective layer 175 are two separate structural layers, the refractive index of the second protective layer 175 and the first protective layer 174 may be the same or different, and the refractive index of the second protective layer 175 may be greater than, equal to, or less than the refractive index of the color filter 182 and/or the adhesive layer 150.

It should be noted herein that the values and ranges of values involved in the embodiments of the present application are approximations, and under the influence of the manufacturing process, there may exist a certain range of error, which may be considered negligible by persons of ordinary skill in the art.

Finally, it should be noted that the foregoing embodiments are merely used for illustrating the technical solutions of the present application other than limiting the present application; although the present application has been described in detail with reference to the foregoing embodiments, persons of ordinary skill in the art should understand that they may still make modifications to the technical solutions described in the foregoing embodiments or make equivalent substitutions to some or all of the technical features thereof; and such modifications or substitutions do not make the essence of the corresponding technical solutions depart from the scope of the technical solutions of the embodiments of the present application.

## Claims

1. A display panel, comprising: a light-emitting region and a non-light-emitting region located at a periphery of the light-emitting region; the display panel comprises a light-emitting side and a backlight side disposed opposite to each other along a thickness direction;
the display panel comprises a touch layer and a filter layer located in the touch layer, the filter layer comprises a color filter, the touch layer comprises a first touch wire and a second touch wire, the second touch wire is located at the first touch wire close to the light-emitting side;
the color filter comprises a first color filter and a second color filter, the first color filter is located at the light-emitting region, the second color filter, the first touch wire and the second touch wire are all located at the non-light-emitting region, and the second color filter is located between the first touch wire and the second touch wire;
the second color filter and at least part of the first color filter are disposed to be in same layer and of same material, and a gap is disposed between the first color filter and the second color filter.

2. The display panel according to claim 1, wherein the first color filter comprises a plurality of sub-color filters that have different colors and are disposed at intervals, and the second color filter is disposed to be in same layer and of same material as the sub-color filters having at least one color.

3. The display panel according to claim 1, wherein the second color filter has a via-hole running through the second color filter along a thickness direction, and the second touch wire covers a hole wall surface of the via-hole and is connected with the first touch wire;
a size of an opening of the via-hole gradually increases along a direction from the backlight side to the light-emitting side.

4. The display panel according to any one of claims 1-3, wherein the filter layer further comprises a light-shielding layer, at least part of the light-shielding layer is located at the second touch wire close to the light-emitting side.

5. The display panel according to claim 4, wherein a positive projection of the light-shielding layer on a plane where the first touch wire is located covers the first touch wire.

6. The display panel according to claim 4, wherein a positive projection of the light-shielding layer on a plane where the second touch wire is located covers the second touch wire.

7. The display panel according to claim 4, wherein at least part of the first color filter extends to the non-light-emitting region, the light-shielding layer is located at the first color filter close to the light-emitting side, and a positive projection of the first color filter located in the non-light-emitting region on a plane where the light-shielding layer is located partially overlaps the light-shielding layer.

8. The display panel according to claim 4, wherein a positive projection of the second touch wire on a plane where the second color filter is located is located on an inner side of an outer edge of the second color filter.

9. The display panel according to claim 4, wherein the light-shielding layer is located in the gap.

10. The display panel according to claim 4, wherein a space between the first color filter and the second color filter gradually increases along a direction from the backlight side to the light-emitting side.

11. The display panel according to claim 4, wherein a protective layer is disposed in the touch layer, and at least part of the protective layer is located at the first color filter close to the light-emitting side.

12. The display panel according to claim 11, wherein the protective layer comprises a first protective layer, and the first protective layer covers a surface of the first color filter close to the light-emitting side.

13. The display panel according to claim 12, wherein a refractive index of the first color filter is less than a refractive index of the first protective layer.

14. The display panel according to claim 12, wherein the display panel comprises an adhesive layer, the adhesive layer is located at the touch layer close to the light-emitting side, and a refractive index of the adhesive layer is less than a refractive index of the first protective layer.

15. The display panel according to claim 12, wherein the protective layer comprises a second protective layer, the second protective layer is located on at least one of a surface of the light-shielding layer close to the light-emitting side and a surface of the light-shielding layer close to the backlight side.

16. The display panel according to claim 15, wherein the first protective layer and the second protective layer are an integrated member.

17. The display panel according to claim 2, wherein the first color filter has a thickness in a range of 0.5 µm-5 µm; and/or, the second color filter has a thickness in a range of 0.5 µm-15 µm.

18. The display panel according to claim 2, wherein the color filter has a dielectric constant of less than or equal to 10; and/or, the color filter has a surface impedance of greater than or equal to 10¹¹ Q/square.

19. A display device, comprising the display panel according to claim 1.
